# EUROPEAN PATENT APPLICATION

(11) **EP 2 063 368 A2**
(43) Date of publication of application: **27.05.2009**
(21) Application number: 08162819.0
(22) Date of filing: 22.08.2008
(51) Int. Cl.: G06F 17/50

(54) **Counter example analysis support apparatus**

(30) Priority: 15.11.2007 JP 2007296713
(71) Applicant: Kabushiki Kaisha Toshiba, Minato-ku, Tokyo 105-8001 (JP)
(72) Inventor: Takada, Satoko, Tokyo 105-8001 (JP); Murata, Yukari, Tokyo 105-8001 (JP); Ikeda, Nobuyuki, Tokyo 105-8001 (JP)
(74) Representative: HOFFMANN EITLE

(57) **Abstract**

A counter example analysis support apparatus includes a counter example storage storing the counter example being a transition sequence of state and event that has not satisfied a verification condition as a result of the model checking; comprising: a related item list storage storing a related item list being a list associating a detection event, which is an event for detecting and generating the other-state, and a detected state, which is a state for determining the existence of the generation of the detection event; and a searching unit outputting a possible problem part from the counter example, wherein the searching unit determines whether a state included in the counter example is the detected state, and if the state included in the counter example is the detected state, determines whether a detection event corresponding to the related item list is generated before the detected state transits to a next state.

## Description

### CROSS-REFERENCE TO RELATED APPLICATION

This application is based on and claims the benefit of priority from the prior Japanese Patent Application No. 2007-296713, filed on November 15, 2007, the entire contents of which are incorporated herein by reference.

### BACKGROUND OF THE INVENTION

### Field of the Invention

The present invention relates to a counter example analysis support apparatus that extracts a possible problem part in a counter example that is a verification result obtained by performing model checking.

### Description of the Related Art

More errors now occur due to the complication of software, and manual and comprehensive verification of specifications has become difficult. It is hard to discover an error without experience and knowledge if the error occurs at the design stage of the system, and enormous costs are needed to remove an error discoverer in post-processing. Therefore, an approach that enables the early detection of an error of specifications and the comprehensive verification of the specifications is essential.

As means to solve such a problem, the model checking, one of the formal methods, has attracted attention as a method of early detection of a failure in upstream processes, the model checking targeting software such as an embedded system whose main object is to control a device.

### [Model Checking]

The model checking is a method of proving the correctness of specifications by expressing the specifications of the system with a state transition model, describing the property (verification condition) that the system must satisfy with a logical expression, and verifying whether the state transition model satisfies the logical expression (for example, JP-A 2002-324098 (Kokai)). Once the designer creates the state transition model and performs the model checking after finding the required verification condition, a model checker performs comprehensive and automatic verification and verifies whether the verification condition is satisfied. If the state transition model does not satisfy the verification condition, the model checker outputs a state transition sequence leading to the state as a counter example. A defect of the specifications can be discovered by analyzing the counter example and finding the reason why the model does not satisfy the verification condition.

In JP-A 2002-324098, the model checking is performed by extracting information related to a condition determination formula based on the sources described in a hardware description language and dividing the information into an assembly that satisfies the condition determination formula and an assembly that does not satisfy the condition determination formula. In the conventional technology, the number of times of verification with the model checking is increased as the information is divided into assemblies. Therefore, the possibility of finding a plurality of counter examples is increased, and the developer can easily understand and review because the place of the part corresponding to the counter example can be limited by narrowing down the verification subject.

However, it is required that the sources be already described in the hardware description language. Furthermore, although the range of the output of the counter example is narrowed down, the content of the output of the counter example is redundant. Therefore, a counter example affected by a plurality of conditional branches cannot be verified.

In general, there is a problem that manual analysis of the counter example takes a lot of time because the outputted counter example is tracked step by step and the cause of the counter example being outputted is searched while comparing the counter example with the state model or the specifications. This is because the conventional technique is distinct in that the parts that do not have to be tracked need to be checked, and the cause may not exist near the part that does not satisfy the verification condition.

An object of the present invention is to provide a technique that enables verification if a state model is designed and that supports the counter example decoding of the user who extracts a problem or a possible problem part generated in a state transition model included in the counter example to thereby perform a verification operation even in a redundant counter example.

### SUMMARY OF THE INVENTION

The present invention is characterized as follows as means for solving the above problem.

A first aspect of the present invention is proposed as a counter example analysis support apparatus that outputs a possible problem part included in a counter example that is a verification result obtained by performing model checking.

The counter example analysis support apparatus comprises: a counter example storage to store the counter example that is a transition sequence of state and event that has not satisfied a verification condition as a result of the model checking; a related item list storage to store a related item list that is a list of items correlated with an other-state and that associates a detection event, which is an event for detecting and generating the other-state, and a detected state, which is a state for determining the existence of the generation of the detection event; and a searching unit to output a possible problem part, which is a part that may have a problem, from the counter example using the counter example and the related item list, wherein the searching unit determines whether a state included in the counter example is the detected state, and if the state included in the counter example is the detected state, determines whether a detection event corresponding to the related item list is generated before the detected state transits to a next state and outputs a possible problem part if the searching unit determines that the detection event is not generated.

A second aspect of the present invention is proposed as a method of outputting a possible problem part included in a counter example that is a verification result obtained by performing model checking, comprising: storing the counter example that is a transition sequence of state and event that has not satisfied a verification condition as a result of the model checking; storing a related item list that is a list of items correlated with an other-state and that associates a detection event, which is an event for detecting and generating the other-state, and a detected state, which is a state for determining the existence of the generation of the detection event; and determining whether a state included in the counter example is the detected state, determining whether a detection event corresponding to the related item list is generated before the detected state transits to a next state if the state included in the counter example is the detected state, and outputting a possible problem part if it is determined that the detection event is not generated.

### BRIEF DESCRIPTION OF THE DRAWINGS

FIG. 1 depicts a flow of general model checking;
FIG. 2 depicts an output example of a counter example outputted by a model checker;
FIG. 3 depicts an example of a program of a plurality of concurrently operated processes;
FIG. 4 depicts a table showing state transitions of the processes when two processes are concurrently operated;
FIG. 5 is a functional block diagram showing a configuration example of a counter example analysis support apparatus;
FIG. 6 depicts an example of a state transition table which is an input used to prepare a state transition model;
FIG. 7 depicts an example of a related item list created from the state transition table shown in FIG. 6;
FIG. 8 is a flow chart of an example of a counter example analysis process equivalent to an operational example of the counter example analysis Support apparatus;
FIG. 9 is a flow chart showing a more specific process of the counter example analysis process;
FIG. 10 is a sequence diagram illustrating a content of the counter example outputted by the model checker in a certain state transition model; and
FIG. 11 depicts an example of a related item list created from a state transition table corresponding to the counter example of FIG. 10.

The accompanying drawings, which are incorporated in and constitute a part of the specification, illustrate embodiments of the invention, and together with the general description given above and the detailed description of the embodiments given below, serve to explain the principles of the invention.

### DETAILED DESCRIPTION OF THE PREFERRED EMBODIMENTS

Embodiments of the present invention will now be described with reference to the drawings.

### [1. Model Checking]

A counter example as a subject of processing by a counter example analysis support apparatus according to the present embodiment and model checking as a process for generating the counter example will be described first.

The "model checking" is a method of proving the correctness of specifications by expressing the specifications of the system with a state transition model, describing the verification condition with a logical expression, and verifying whether the state transition model satisfies the logical expression. The designer needs to create the state transition model and find the required verification condition. The "verification condition" herein denotes a requirement specification that the system needs to satisfy.

Once the model checking is performed, a model checker performs comprehensive and automatic verification to verify whether the verification condition is satisfied. If the state transition model does not satisfy the verification condition, the model checker outputs a state transition sequence leading to the state as a counter example. A defect of the specifications of the system expressed with the state transition model can be found by analyzing the counter example and finding the reason why the state transition model does not satisfy the verification condition.

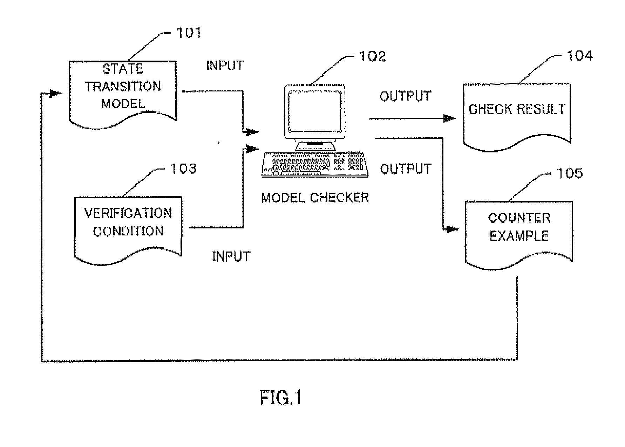

FIG. 1 depicts a flow of the model checking. When performing the model checking, the model verifier creates a state transition model 101, inputs the state transition model 101 to a model checker 102, creates a verification condition 103, and inputs the verification condition 103 in the model checker 102. The model checker 102 is a device, such as a computer installed with a program for executing the model checking, that executes the state transition of the model or that generates an event based on the state transition model 101. The verification condition is a condition, such as "process P1 and process P2 do not become states S5 and S4 at the same time", that the system expressed by the state transition model needs to satisfy.

The model checker 102 performs a model checking process based on the inputted state transition model 101 and the verification condition 103, and if a check result 104 and the verification condition are not satisfied, outputs a counter example 105.

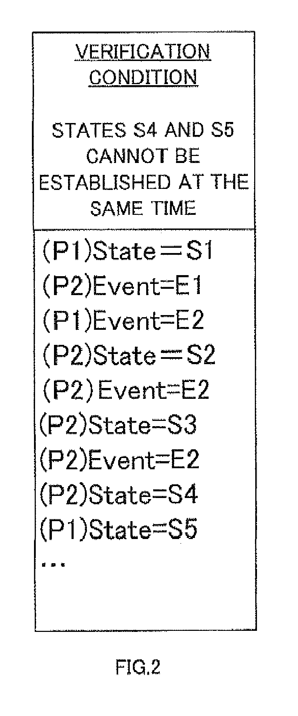

FIG. 2 depicts an output example of the counter example 105 outputted by the model checker 102. In the output example of the counter example 105, the verification condition 103 is illustrated in the upper part, while a transition sequence of state and event as a content of the counter example 105 is illustrated below.

The "counter example" is a transition sequence of state or event that has not satisfied the verification condition as a result of the model checking, the transition sequence being outputted as a log. As the counter example 105 outputs a specific example indicative of a fact that the "verification condition is not satisfied", the model verifier needs to find the cause (part that needs to be modified) of the output of the counter example 105. The readability of the counter example 105 is low because the transition sequence of state or event is outputted in sequence. Therefore, if a process for finding the cause from the counter example 105 is performed manually, much operating time is required. Specifically, the model verifier performs a required operation of finding, from the counter example 105, the fundamental cause of the output of the counter example 105, reviewing how to modify the specifications with respect to the causal part, modifying the specifications based on the result of review, and performing the model checking again.

If a plurality of processes are concurrently operated in the state transition model to be checked, the consistency may be lost due to the deviation of the execution timing. In this case, it takes time to discover the problem causing part because there is often no problem when the transitions of the processes alone are observed.

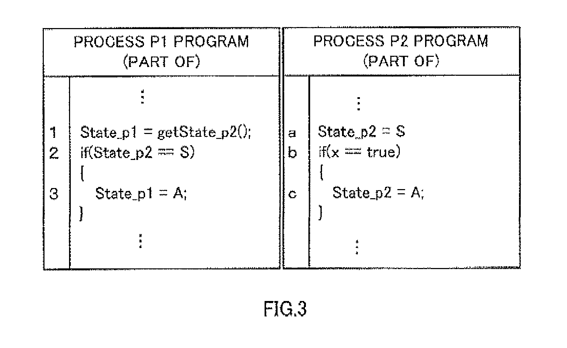

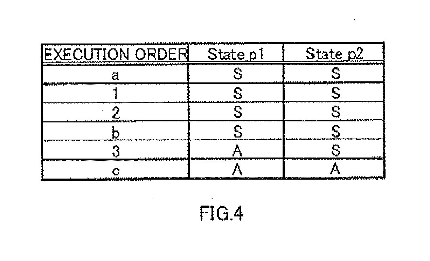

FIG. 3 depicts an example of programs of a plurality of processes operated concurrently. In the example, the verification condition 103 is assumed to be both of the state of a process P1 "State_p1" and the state of a process P2 "State_p2" cannot be "A" at the same time. FIG. 4 is a table showing state transitions of the processes when two processes shown in FIG. 3 are concurrently operated to check whether the verification condition 103 is satisfied. In the table of FIG. 4, the left column shows an execution order of the steps of the process, the middle column shows the state of the process P1, and the right column shows the state of the process P2.

The state transitions of the processes P1 and P2 in the example will be described with reference to FIGS. 3 and 4. A step a of the process P2 is first executed. In the step a, a value "S" is substituted for the state of the process P2 "state_p2", and the state "State_p2" becomes "S". At this point, the state of the process P1 "State_p1" is "S".

A step 1 of the process P1 is then executed. The process P1 acquires a value of the state of the process p2 "Stato_p2". The value of the acquired state "State_p2" is "S". At this point, both of the state of the process P1 "State_p1" and the state of the process P2 "State_p2" remain "S".

A step 2 of the process P1 is then executed. Specifically, the process 1 determines whether the state of the process P2 "State_p2" is "S". At this point, both of the state of the process P1 "State_p1" and the state of the process P2 "State_p2" remain "S".

A step b of the process P2 is then executed. Specifically, the process P2 determines whether a value of a variable X is "true". At this point, both of the state of the process P1 "State_p1" and the state of the process P2 "State_p2" remain "S".

A step 3 of the process P1. is then executed. Specifically, "A" is substituted for the state of the process P1 "State_p1". At this point, the state of the process P1. "State_p1" transits to "A", and the state of the process P2 "state_p2" remains "S".

A step c of the process P2 is then executed. Specifically, the process P2 substitutes "A" for the state of the process P2 "State_p2". At this point, the state of the process P1 "State_p1" is "A", and the state of the process P2 "State_p2" transits to "A". Therefore, a state contrary to the condition "state of process P1 'State_p1' and state of process P2 'State_p2' cannot be 'A' at the same time", which is the verification condition 103, is generated. The cause of the problem is that the deviation in the execution timing is generated (the state "State_p2" is changed after the process p1 has acquired the state "State_p2"). However, it is not easy to perceive the deviation in such execution timing from the counter example 105. Therefore, it is not easy for an unpracticed model verifier to find the problem causing part.

### [2. Counter Example Analysis Support Apparatus]

The present embodiment proposes a counter example analysis support apparatus that is a device for analyzing the counter example 105, presenting the possible problem part (part assumed to be the cause of the problem) included in the counter example 105, and improving the efficiency of the counter example analysis. A prerequisite for applying the present embodiment is that the verification subjects are a plurality of independent modules and there is a correlation (such as a parallel process) .

The counter example analysis support apparatus is an information process device, such as a computer, a workstation, and a microcomputer (microprocessor), that includes a central processing unit (CPU), a main memory (RAM), a read-only memory (ROM), an input/output device (I/O), and an external storage device such as a hard disk drive if necessary. A program for causing the information processing device to function as a counter example analysis support apparatus is stored in the ROM, the hard disk drive, or the like. The program is installed in the main memory, and the CPU executes the program to realize the counter example analysis support apparatus.

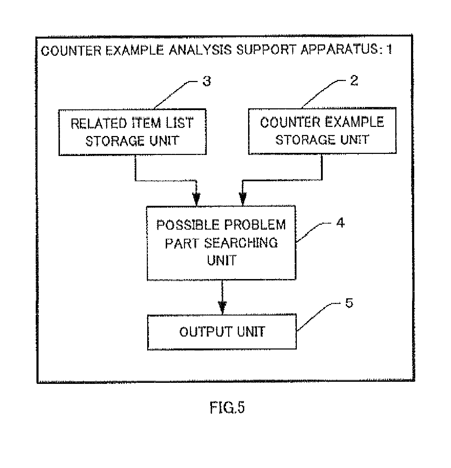

FIG. 5 is a functional block diagram showing a configuration example of the counter example analysis support apparatus. A counter example analysis support apparatus 1 shown in FIG. 5 includes a counter example storage unit 2 equivalent to counter example storage unit of the present invention, a related item list storage unit 3 equivalent to related item list storage unit of the present invention, a possible problem part searching unit 4 (equivalent to searching unit of the present invention) connected to the counter example storage unit 2 and the related item list storage unit 3, and an output unit 5 connected to the possible problem part searching unit 4. The possible problem part searching unit 4 is a constituent element realized by the CPU executing a program and does not have to be an individual circuit or device. Meaning of "connected" herein includes a state in which data can be transferred and does not only mean a physical connection.

Although the model checker 102 and the counter example analysis support apparatus 1 are described as separate devices in the present embodiment, a single computer may function as the model checker 102 and the counter example analysis support apparatus 1.

Each of the constituent elements of the counter example analysis support apparatus 1 will be described in detail.

### [2.1. Counter Example Storage Unit]

The counter example storage unit 2 includes a function of storing the counter example 105 outputted from the model checker 102 as data readable by the possible problem part searching unit 4. Although the counter example storage unit 2 is primarily constituted by a storage device such as a memory and a hard disk storage device, the counter example storage unit 2 may be a storage medium (such as a CD and a USB memory) storing the data of the counter example 105.

### [2.2. Related Item List Storage Unit]

Although the related item list storage unit 3 is primarily constituted by a storage device such as a memory and a hard disk storage device, the related item list storage unit 3 may be a storage medium (such as a CD and a USB memory) storing a related item list. The related item list storage unit 3 includes a function of storing a related item list that is a list of items correlated with an other-state extracted from a state transition table (corresponding to the state transition model 101). The "other-state" herein denotes a state of a process (called other-process) other than a certain process (called present-process) among a plurality of processes. The model verifier or the like creates the related item list based on the state transition table corresponding to the state transition model 101. "Items correlated with other-state" stored in the related item list are the following four items.
(1) Event generated by detecting an other-state (hereinafter "detection event").
(2) State of determining the existence of the generation of the event (hereinafter "detected state").
(3) State of the present-process that may generate an event correlated with the other-state, i.e. the detection event (hereinafter "present-state").
(4) State after transition of the present-process when an event correlated with the other-state, i.e. the detection event, is generated (hereinafter "present-state after transition").

A creating method of the related item list will be described next.

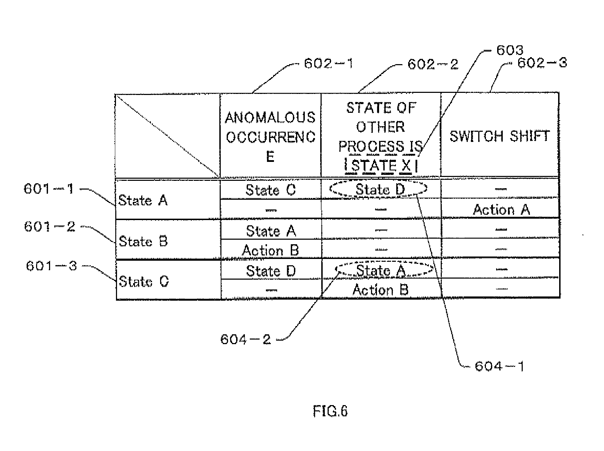

FIG. 6 depicts an example of the state transition table created based on the state transition model 101. The "state transition table" expresses the behavior of the system in a tabular form with a combination of event and state. Actions and states after transition are described with respect to the combinations of event and state.

The state transition table shown in FIG. 6 is tabular form data constituted by three kinds of states "State A", "State B", and "State C" and three kinds of events "ANOMALOUS OCCURRENCE", "STATE OF OTHER-PROCESS IS State X", and "SWITCH SHIFT ". Three kinds of states 601-1 to 601-3 correspond to three rows, while three kinds of events 602-1 to 602-3 correspond to three columns.

The state transition table includes nine cells in total with three rows and three columns. The "cells" denotes sections in the state transition table. Each cell corresponds to a combination of an event and a state. Each cell stores a state after transition when an event corresponding to the column including the cell is generated in the state corresponding to the row including the cell and/or an action to be generated. However, data is not stored when the transition of state does not occur and/or when no action is generated (such a case is illustrated with a symbol "-" in FIG. 6).

The model verifier extracts the above described "items correlated with other-state" from the state transition table. In an example shown in FIG. 6, the detected state is "State X" (reference numeral 603 in FIG. 6). The detection event is "STATE OF OTHER-PROCESS IS State X" which is the event 602-2. The present-states are the state "State A" (reference numeral 601-1) and the state "State C" (reference numeral 601-3). The present-states after transition are a state "State D" (reference numeral 604-1) and the state "State A" (reference numeral 604-2).

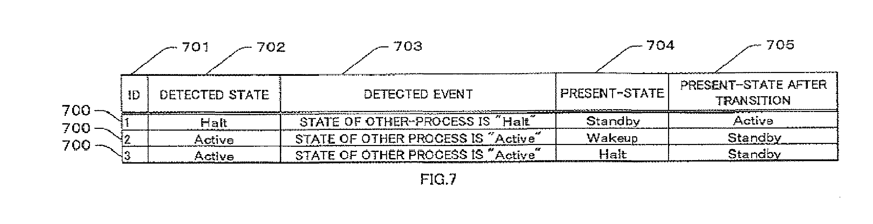

The data representation of the "items correlated with other-state" is the related item list. FIG. 7 depicts an example of the related item list created from the state transition table shown in FIG. 6. As shown in FIG. 7, the related item list includes a plurality of records 700, and each record 700 has items (fields) including an ID 701, a detected state 702, a detection event 703, a present-state 704, and a present-state after transition 705. The ID denotes a list number of a certain item correlated with the other-state.

The related item list is stored in the related item list storage unit 3 as data, and the possible problem part searching unit 4 refers to the related item list when the possible problem part searching unit 4 searches the possible problem part.

### [2.3. Possible Problem Part Searching Unit]

The possible problem part searching unit 4 uses the counter example 105 stored in the counter example storage unit 2 and the related item list stored in the related item list storage unit 3 to search a part that may have a problem (possible problem part) from the counter example 105. The possible problem part searching unit 4 then generates and outputs data (called possible problem part indication data) indicating the possible problem part that is a part found as a possible part of the cause of the problem a result of the analysis from the counter example 105 and the related item list. An operation of the possible problem part searching unit 4 will be described later. [2.4. Output Unit]

The output unit 5 includes a function of outputting the possible problem part indication data outputted by the possible problem part searching unit 4 in a form in which the user or the operator of the model verifier or the like can recognize the problem causing part in the counter example. The output form can be any form such as displaying, printing, and data outputting.

The output of the output unit 5 may have any display form. For example, the output is provided as a report presenting a row number of the counter example corresponding to the possible problem part as an analysis result based on information for identifying the possible problem part identified by the search of the possible problem part searching unit 4. Alternatively, a symbol (for example, *) may be attached to the possible problem part of the counter example. The output unit 5 is, for example, a writing device for writing into a liquid crystal display device, a printer, or a storage medium.
[3. Operation Example of Counter Example Analysis Support Apparatus] An operation example of the counter example analysis support apparatus 1 will be described.

### [3.1. Operation Procedure of Designer and System]

An outline of a process until the counter example analysis support apparatus 1 outputs the possible problem part will be described first.
(1) A model verifier (system designer or the like) creates the state transition model 101 of system as a verification subject and the verification condition 103 and then inputs the state transition model 101 and the verification condition 103 in the model checker 102. The model checker 102 performs the model checking and outputs the counter example 105.
(2) The model verifier extracts items correlated with the other-state from the state transition model 101 and creates the related item list.
(3) The model verifier stores the counter example 105 and the "related item list" in the counter example storage unit 2 and the related item list storage unit 3 of the counter example analysis support apparatus 1, respectively.
(4) The model verifier causes the counter example analysis support apparatus 1 to execute a search process of the possible problem part in the counter example. The counter example analysis support apparatus 1 searches the possible problem part by the possible problem part searching unit 4 using the counter example and the "related item list".
(5) The counter example analysis support apparatus 1 outputs a report that indicates the obtained possible problem part (for example, the row in the counter example text corresponding to the obtained possible problem part) .
(6) The model verifier modifies the state transition model or performs other actions based on the report outputted by the counter example analysis support apparatus 1.

### [3.2. Algorithm of Possible Problem Part Search Process]

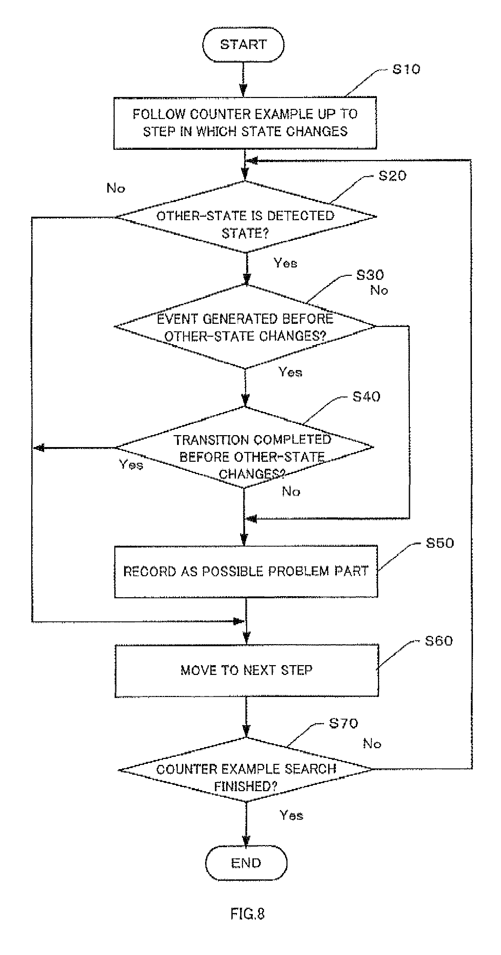

FIG. 8 illustrates a flow chart of an example of the counter example analysis process equivalent to an operational example of the counter example analysis support apparatus 1. Hereinafter, a counter example analysis process as an operation example of the counter example analysis support apparatus 1, more specifically, the possible problem part searching unit 4 will be described with reference to FIG. 8.

The possible problem part searching unit 4 first follows the counter example 105, which is stored in the counter example storage unit 2, step by step and moves to the step in which the state changes (S10). The destination step will be referred to as verification subject step.

The possible problem part searching unit 4 then determines whether the state indicated by the verification subject step is the detected state of the related item list (S20). If the state indicated by the verification subject step is not the detected state (S20, No), the possible problem part searching unit 4 moves to the next step in the counter example 105 (S60).

After moving to the next step, the possible problem part searching unit 4 determines whether there is no more subsequent steps in the counter example 105 so that the search of the counter example is finished (S70). If the possible problem part searching unit 4 determines that the search of the counter example is finished (S70, Yes), the possible problem part searching unit 4 ends the search of the possible problem part. On the other hand, if the possible part searching unit 4 determines that the search of the counter example is not finished (S70, No), the possible problem part searching unit 4 returns to S20, sets the destination step as a new verification subject step, and determines whether the state indicated by the verification subject step is in the detected state (S20).

Meanwhile, if the possible problem part searching unit 4 determines in S20 that the state indicated by the step is the detected state (S20, Yes), the possible problem part searching unit 4 determines whether the event corresponding to the related item list is generated in the present-state (present-process) before the detected state transits to the next state (S30).

If such an event is not generated, there may be a problem that the state is not detected. Even if the event is generated, there may be a problem that the timing of detection is deviated if the event does not correspond to the related item list.

If the possible problem part searching unit 4 determines in step S30 that the event corresponding to the related item list is not generated in the present-state (present-process), the possible problem part searching unit 4 records the part (step) of the counter example 105 as a possible problem part (S50).

Meanwhile, if the possible problem part searching unit 4 determines in S30 that the event corresponding to the related item list is generated in the present-state or the present-process (S30, Yes), the possible problem part searching unit 4 determines whether the transition of the present-state is completed before the detected state transits to the next state (S40). If the other-state has transited to another state before the transition of the present-state (present-process) is completed, there may be a problem that the processes are not consistent.

If the possible problem part searching unit 4 determines that the transition of the present-state (present-process) is completed before the detected state transits to the next state (S40, Yes), the possible problem part searching unit 4 moves to the next step in the counter example 105 (S60).

Meanwhile, if the possible problem part searching unit 4 determines in S40 that the transition of the present-state (present-process) is not completed before the detected state transits to the next state, i.e., the detected state has transited to the next state before the transition of the present-state is completed (S40, No), the possible problem part searching unit 4 records the part (step) as a possible problem part (S50) and then proceeds to S60.

The counter example analysis support apparatus 1 repeats S10 to S70 described above, determines for all steps in the counter example whether the steps are possible problem parts, records the step determined to be a possible problem part, and causes the output unit 5 to output the recorded step as a possible problem part on a report.

### [3.3 Specific Example of Counter Example Analysis Process]

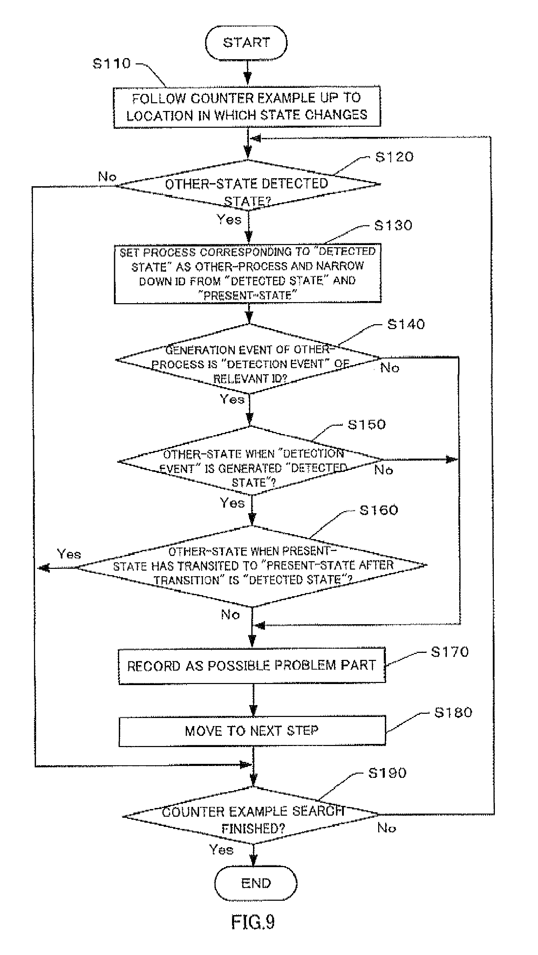

Next, a specific example of the counter example analysis process described using FIG. 8 will be described with reference to FIG. 9. FIG. 9 is a flow chart showing a more specific process of the counter example analysis process.

The possible problem part searching unit 4 first follows the counter example 105, which is stored in the counter example storage unit 2, step by step and moves to the step in which the state changes (S110). This process is equivalent to S10 of FIG. 8.

The possible problem part searching unit 4 then determines whether the state indicated by the verification subject step is the detected state of the related item list (S120). This is equivalent to S20 of FIG. 8. If the state indicated by the verification subject step is not the detected state (S120, No), the possible problem part searching unit 4 moves to the next step in the counter example 105 (S180). After moving to the next step, the possible problem part searching unit 4 determines whether there is no subsequent steps in the counter example 105 so that the search of the counter example is finished (S190). If the possible problem part searching unit 4 determines that the search of the counter example is finished (S190, Yes), the possible problem part searching unit 4 ends the search of the possible problem part. On the other hand, if the possible problem part searching unit 4 determines that the search of the counter example is not finished (S190, No), the possible problem part searching unit 4 returns to S120, sets the destination step as a new verification subject step, and determines whether the state indicated by the verification subject step matches with any of the detected states included in the related item list (S20).

Meanwhile, if the possible problem part searching unit 4 determines in S120 that the state indicated by the verification subject step is the detected state (S120, Yes), the possible problem part searching unit 4 sets the process corresponding to the detected "detected state" as the other-process, sets the other process or another process as the present-process, and narrows down and identifies the "ID" of the related item list in which the state of the other-process is "detected state" and the state of the present-process is "present-state" (S130).

The possible problem part searching unit 4 then determines whether the event generated next in the other-process is the same as the "detection event" corresponding to the ID identified in S130 to examine whether the event intended in the specifications is generated (S140). If the possible problem part searching unit 4 determines that the event is not the same as the "detection event" corresponding to the identified ID (S140, No), the possible problem part searching unit 4 records the part (step) of the counter example 105 as a possible problem part (S170) and then proceeds to S180 and S190.

Meanwhile, if the possible problem part searching unit 4 determines in S140 that the event generated next in the other-process is the same as the "detection event" corresponding to the ID identified in S130 (S140, Yes), the possible problem part searching unit 4 determines whether the other-state when the "detection event" corresponding to the relevant ID of the related item list is generated remains being the "detected state", i.e. whether the other-state is not changed, to examine whether the event is generated in appropriate timing (S150). If the possible problem part searching unit 4 determines in S150 that the other-state when the "detection event" is generated does not remain being the "detected state" (S150, No), the possible problem part searching unit 4 records the part (step) of the counter example 105 as a possible problem part (S170) and then proceeds to S180 and S190.

On the other hand, if the possible problem part searching unit 4 determines in S150 that the other-state when the "detection event" is generated remains being the "detected state" (S150, Yes), the possible problem part searching unit 4 determines whether the other-state when the present-process has transited to the "present-state after transition" in the relevant ID of the related item list is the "detected state" to examine whether the present-state at the completion of the transition is consistent with the other-state (S160). If the possible problem part searching unit 4 determines that the other-state when the present-process has transited to the "present-state after transition" in the relevant ID is not the "detected state" (S160, No), the possible problem part searching unit 4 records the part (step) of the counter example 105 as a possible problem part (S170) and then proceeds to S180 and S190.

Meanwhile, if the possible problem part searching unit determines in S160 that the other-state when the present-process has transited to the "present-state after transition" in the relevant ID is the "detected state" (S160, Yes), the possible problem part searching unit 4 moves to the next step in the counter example 105 (S180), and then proceeds to S190 described above.

The counter example analysis support apparatus 1 repeats S110 to S190 described above, determines for all steps in the counter example whether the steps are possible problem parts with reference to the problem item list, records the step determined to be a possible problem part, and causes the output unit 5 to output the recorded step as a possible problem part on a report.

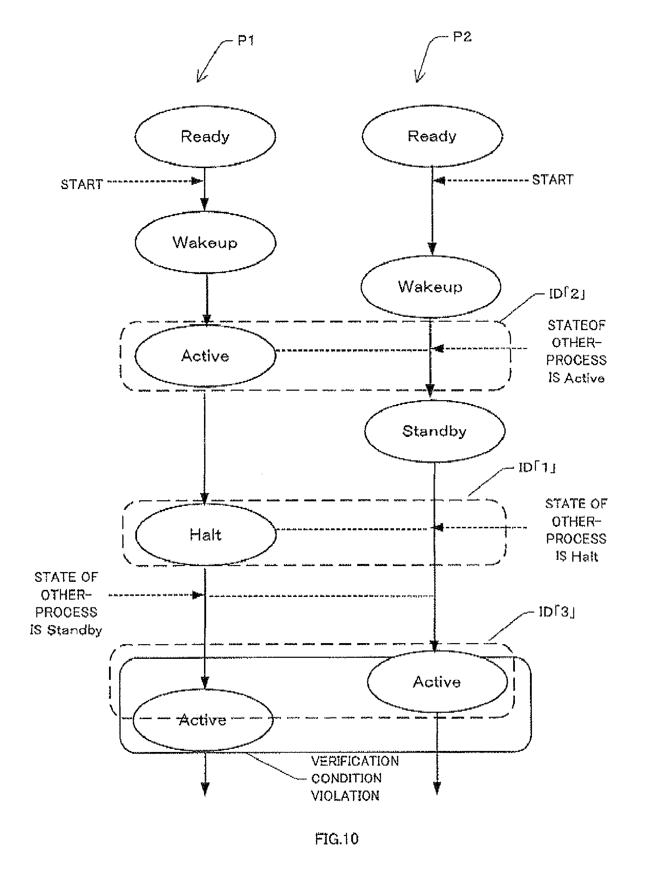

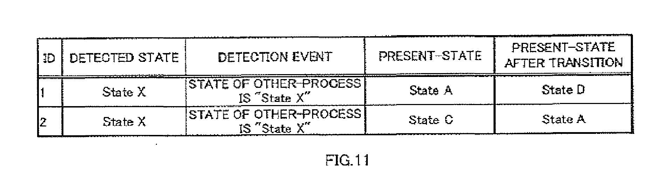

A further specific example of the counter example analysis process (operation of the counter example analysis support apparatus 1) shown in FIG. 9 will be described with reference to FIGS. 10 and 11. FIG. 10 is a sequence diagram illustrating a content of the counter example 105 outputted by the model checker 102 in a certain state transition model. FIG. 11 depicts an example of a related item list created from a state transition table corresponding to the counter example 105 of FIG. 10. It is assumed that the verification condition 103 as a requirement of the counter example 105 is "states of a plurality of processes do not become 'Active' at the same time".

Two processes P1 and P2 are verified in the counter example 105 shown in FIG. 10.

In the process P1, after an event "START" is generated, the state transits in order of "Wakeup", "Active", "Halt", and "Active". In the process P1, after the state "Halt", a detection event "STATE OF OTHER-PROCESS IS 'Standby'" is generated.

Meanwhile, in the process P2, after the generation of the event "START", the state transits in order of "Wakeup", "Standby", and "Active".) In the process P2, a detection event "STATE OF OTHER-PROCESS IS 'Active'" is generated after the state "Wakeup", and a detection event "STATE OF OTHER-PROCESS IS 'Halt'" is generated after the state "Standby". It is assumed that the timing and the context of the state transitions and the event generations are as shown n FIG. 10.

After starting the counter example analysis process shown in FIG. 9, the counter example analysis support apparatus 1, more specifically, the possible problem part searching unit 4 first determines whether the state of the process P1 "Wakeup" corresponds to any of the items of the "DETECTED STATE" in the problem item list shown in FIG. 11 (see FIG. 9, S120). Since there is no record including "Wakeup" in the "DETECTED STATE" of the problem item list shown in FIG. 11, the counter example analysis support apparatus 1, more specifically, the possible problem part searching unit 4 moves to the state of the process P2 "Wakeup" which is the next state.

The counter example analysis support apparatus 1, more specifically, the possible problem part searching unit 4 moves to the state of the process P2 "Wakeup" and determines whether the state of the process P2 "Wakeup" corresponds to any of the items of the "DETECTED STATE" in the problem item list shown in FIG. 11 (see FIG. 9, S120). As in "Wakeup" of the process P1, since there is no record including "Wakeup" in the "DETECTED STATE" in the problem item list shown in FIG. 11, the counter example analysis support apparatus 1, more specifically, the possible problem part searching unit 4 moves to the state of the process P1 "Active" which is the next state.

The counter example analysis support apparatus 1, more specifically, the possible problem part searching unit 4 moves to the state of the process P1 "Active" and determines whether this corresponds to any of the items of the "DETECTED STATE" in the problem item list shown in FIG. 11 (see FIG. 9, S120).

There are two records of IDs "2" and "3" in which the item "DETECTED STATE" of the related item list is "Active". In this case, the counter example analysis support apparatus 1, more specifically, the possible problem part searching unit 4 examines the present-state to identify one of the records. In the example of FIG. 10, the present-state corresponds to the state of the process P2, which is "Wakeup" in this case. Therefore, the counter example analysis support apparatus 1, more specifically, the possible problem part searching unit 4 identifies the record of ID "2" in which the item "PRESENT-STATE" is "Wakeup" (see FIG. 9, S130).

Next, the counter example analysis support apparatus 1, more specifically, the possible problem part searching unit 4 determines whether the detection event in the process P2 as the other-process matches with the "DETECTION EVENT" of the ID "2". In the example of FIG. 10, the possible problem part searching unit 4 determines that the detection event "STATE OF OTHER-PROCESS IS Active" in the process P2 matches with the "DETECTION EVENT" of the ID "2" (see FIG. 9, S140).

The counter example analysis support apparatus 1, more specifically, the possible problem part searching unit 4 checks whether the other-state when the "DETECTION EVENT" is generated is the "DETECTED STATE" (see FIG. 9, S150). In the example of FIG. 10, since the state of the process P1 is "Active" when the detection event "STATE OF OTHER-PROCESS IS Active" in the process P2 is generated, the counter example analysis support apparatus 1, more specifically, the possible problem part searching unit 4 proceeds to the next determination.

The counter example analysis support apparatus 1, more specifically, the possible problem part searching unit 4 checks whether the other-state when the process P2 as the present-process has transited to the "PRESENT-STATE AFTER TRANSITION" is the "DETECTED STATE" (see FIG. 9, S160). In this example, the state of the process P1 as the other-state when the process P2 has transited to the state "Standby" as the "PRESENT-STATE AFTER TRANSITION" is "Active", which matches with the "DETECTED STATE" in the ID "2".

Therefore, the counter example analysis support apparatus 1, more specifically, the possible problem part searching unit 4 does not determine the state "Active" in the process P1, the detection event "STATE OF OTHER-PROCESS IS Active" in the process P2, and the state of the process 2 "Standby" as the present-state after transition as problem parts and does not store them as possible problem parts.

The counter example analysis support apparatus 1, more specifically, the possible problem part searching unit 4 moves to "Standby" of the process P2, which is the next step in the counter example 105 (see FIG. 9, S180), and determines whether the "Standby" corresponds to any of the items of the "DETECTED STATE" in the problem item list shown in FIG. 11 (see FIG. 9, S120). No detected state of the related item list is "Standby", and thus, the possible problem part searching unit 4 does not do anything and moves to "Halt" of the process P1, which is the next step in the counter example 105.

The counter example analysis support apparatus 1, more specifically, the possible problem part searching unit 4 determines whether "Halt" of the process P1 corresponds to any of the items of the "DETECTED STATE" in the problem item list shown in FIG. 11 (see FIG. 9, S120). The item "DETECTED STATE" of the related item list is "Halt" in the record of the ID "1". The counter example analysis support apparatus 1, more specifically, the possible problem part searching unit 4 examines the present-state. In the example of FIG. 10, the present-state corresponds to the state of the process 2, which is "Standby" in this case. Therefore, the counter example analysis support apparatus 1, more specifically, the possible problem part searching unit 4 identifies the record of the ID "1" (see FIG. 9, S130).

The counter example analysis support apparatus 1, more specifically, the possible problem part searching unit 4 determines whether the detection event in the process P2 as the other-process matches with the "DETECTION EVENT" of the ID "1". In the example shown in FIG. 10, the detection event in the process P2 is "STATE OF' OTHER-PROCESS IS Halt". The counter example analysis support apparatus 1, more specifically, the possible problem part searching unit 4 determines that the detection event "STATE OF OTHER-PROCESS IS Halt" in the process P2 matches with the "DETECTION EVENT" of the ID "1" (see FIG. 9, S140).

The counter example analysis support apparatus 1, more specifically, the possible problem part searching unit 4 checks whether the other-state when the "DETECTION EVENT" is generated is the "DETECTED STATE" (see FIG. 9, S150). In the example of FIG. 10, the state of the process P1 is "Halt" when the detection event "STATE OF OTHER-PROCESS IS Halt" in the process P2 is generated. Therefore, the counter example analysis support apparatus 1, more specifically, the possible problem part searching unit 4 determines that the determination condition is satisfied and proceeds to the next determination.

The counter example analysis support apparatus 1, more specifically, the possible problem part searching unit 4 checks whether the other-state when the process P2 has transited to the "PRESENT-STATE AFTER TRANSITION" is the "DETECTED STATE" (see FIG. 9, S160). In this example, the state of the process P1 as the other-state is "Halt" when the process P2 has transited to the state "Active" as the "PRESENT-STATE AFTER TRANSITION", which matches with the "DETECTED STATE" in the ID "1".

Therefore, the counter example analysis support apparatus 1, more specifically, the possible problem part searching unit 4 does not determine the state "Active" in the process P1, the detection event "STATE OF OTHER-PROCESS IS Active" in the process P2, and the state "Standby" in the process P2 as the present-state after transition as possible problem parts and does not store them as possible problem parts.

The counter example analysis support apparatus 1, more specifically, the possible problem part searching unit 4 moves to the state of the process p2 "Active", which is the next state.

There are two records of IDs "2" and "3" in which the item "DETECTED STATE" of the related item list is "Active". In this case, the counter example analysis support apparatus 1, more specifically, the possible problem part searching unit 4 examines the state of the process P1 equivalent to the present-state. In the example of FIG. 10, the state of the process P1 as the present-state is "Halt". Therefore, the counter example analysis support apparatus 1, more specifically, the possible problem part searching unit 4 identifies the record of the ID "3" (see FIG. 9, S130).

The counter example analysis support apparatus 1, more specifically, the possible problem part searching unit 4 determines whether the detection event in the process P1 as the other-process matches with the "DETECTION EVENT" of the ID "3". The detection event "STATE OF OTHER-PROCESS IS Active" that matches with the "DETECTION EVENT" of the ID "3" is not generated in the process P1. Instead, the detection event "STATE OF OTHER-PROCESS IS Standby" is generated. It is speculated that the state Active of the process P2 could not be detected due to the deviation in the detection timing of the partner-state in the process P1.

Therefore, the counter example analysis support apparatus 1, more specifically, the possible problem part searching unit 4 stores the part (detection event "STATE OF OTHER-PROCESS IS Standby" of the process P1, the state of the process P2 "Active", or both) as a possible problem part, and after the completion of the counter example verification, causes the output unit 5 to output that effect.

In this way, the counter example analysis support apparatus 1 can support the counter example analysis by the model verifier by searching the possible problem part included in the counter example 105 and outputting the part.

### [4. Advantages]

Advantages of the present invention are as follows.
(1) According to the present invention, a possible problem part included in a counter example can be presented even if the part is hard for a person to find such as those caused by a slight deviation in the execution timing.
(2) According to the present invention, a failure can be easily identified by automatically presenting a part that may be a factor of the output of the counter example without knowledge or experience of the counter example analysis.
(3) According to the present invention, a reviewed part of the counter example analysis can be narrowed down by automatically presenting a possible part of the cause of the output of the counter example. This enables to reduce the cost needed for the counter example analysis.

### [Merit of the Invention]

According to the present invention, the system can be verified if a state transition model is designed, and the counter example decoding of the user can be supported, the user extracting a possible problem part as a problem generated in the state transition model included in the counter example to thereby perform a verification operation even in a redundant counter example.

Additional advantages and modifications will readily occur to those skilled in the art. Therefore, the invention in its broader aspects is not limited to the specific details or representative embodiments shown and described herein. Accordingly, various modifications may be made without departing from the spirit or scope of the general inventive concept as defined by the appended claims and their equivalents.

## Claims

1. A counter example analysis support apparatus that outputs a possible problem part included in a counter example that is a verification result obtained by performing model checking, comprising:
a counter example storage to store the counter example that is a transition sequence of state and event that has not satisfied a verification condition as a result of the model checking;
a related item list storage to store a related item list that is a list of items correlated with an other-state and that associates a detection event, which is an event for detecting and generating the other-state, and a detected state, which is a state for determining the existence of the generation of the detection event; and
a searching unit to output a possible problem part, which is a part that may have a problem, from the counter example using the counter example and the related item list, wherein:
the searching unit determines whether a state included in the counter example is the detected state, and
if the state included in the counter example is the detected state, determines whether a detection event corresponding to the related item list is generated before the detected state transits to a next state and outputs a possible problem part if the searching unit determines that the detection event is not generated.

2. The support apparatus according to claim 1, wherein the searching unit determines whether a transition of a present-state is completed before the detected state transits to the next state, and if the searching unit determines that the transition of the present-state is not completed, outputs a possible problem part.

3. A method of outputting a possible problem part included in a counter example that is a verification result obtained by performing model checking, comprising:
storing the counter example that is a transition sequence of state and event that has not satisfied a verification condition as a result of the model checking;
storing a related item list that is a list of items correlated with an other-state and that associates a detection event, which is an event for detecting and generating the other-state, and a detected state, which is a state for determining the existence of the generation of the detection event; and
determining whether a state included in the counter example is the detected state, determining whether a detection event corresponding to the related item list is generated before the detected state transits to a next state if the state included in the counter example is the detected state, and outputting a possible problem part if it is determined that the detection event is not generated.

4. The method according to claim 3, further comprising:
determining whether a transition of a present-state is completed before the detected state transits to the next state and outputting a possible problem part if the searching unit determines that the transition of the present-state is not completed.
